# EUROPEAN PATENT APPLICATION

(11) **EP 3 057 232 A1**
(43) Date of publication of application: **17.08.2016**
(21) Application number: 15154508.4
(22) Date of filing: 10.02.2015
(51) Int. Cl.: H03K 17/081, H03K 17/12, H03K 17/567, H02H 3/08

(54) **Circuit breaker device**

(71) Applicant: ABB Technology AG, 8050 Zürich (CH)
(72) Inventor: Rahimo, Munaf, 5619 Uezwil (CH); Canales, Francisco, 5405 Baden-Dättwil (CH); Vemulapati, Umamaheswara, 5430 Wettingen (CH); Steimer, Peter, 5420 Ehrendingen (CH)
(74) Representative: ABB Patent Attorneys

(57) **Abstract**

A circuit breaker device (10) for interrupting a current flow in an electrical circuit and a method for interrupting current flow with such circuit breaker device (10) are proposed. The circuit breaker device (10) comprises a first switch arrangement (12) with a first silicon-based semiconductor switch (14) and a second silicon-based semiconductor switch (16), which are antisymmetrically interconnected with each other. The circuit breaker device (10) further comprises a second switch arrangement (18) with a first wide bandgap semiconductor switch (20) and a second wide bandgap semiconductor switch (22), which are series connected in a back-to-back arrangement. The first switch arrangement (12) is arranged in parallel to the second switch arrangement (18).

## Description

### FIELD OF THE INVENTION

The invention relates to the field of power semiconductor electronics. In particular the invention relates to a circuit breaker device employing a power semiconductor device and to a method for interrupting a current flow in an electrical circuit.

### BACKGROUND OF THE INVENTION

Semiconductor switches based on wide bandgap (WBG) semiconductor materials such as e.g. Silicon Carbide (SiC) and Gallium Nitride (GaN), and in particular unipolar devices, provide low conduction losses and switching losses due to inherent advantages of these materials having thin base layers and low losses at low currents. Wide bandgap semiconductor switches may generally permit energy efficient operation at considerably high voltages, frequencies and/or temperatures compared to conventional semiconductor switches, such as e.g. bipolar silicon (Si) based semiconductor switches.

On the other hand, bipolar silicon-based switches, such as e.g. insulated gate bipolar transistors (IGBT), reverse conducting insulated gate bipolar transistors (RC-IGBT), and bi-mode insulated gate transistors (BIGT), may further provide various advantages compared to wide bandgap switches. For example, bipolar Si based switches may provide good protection characteristics including high current and series connection high voltage capability, a reliable short circuit failure mode, good short circuit capability due to a relatively high saturation current and good surge current capability in diode mode.

US 2014/0185346 A1 relates to a hybrid power device comprising first and second switching devices containing first and second unequal band-gap semiconductor materials, wherein the switching devices are three or more terminal switching devices of different type.

EP 0 443 155 B1 relates to a switchgear employing MOS-FET semiconductors, which are connected in parallel and switchable at high frequencies, and IGBT power semiconductors.

### DESCRIPTION OF THE INVENTION

It is an objective of the present invention to provide a reliable, comprehensive and energy efficient circuit breaker device.

This objective is achieved by the subject-matter of the independent claims. Further exemplary embodiments are evident from the dependent claims and the following description.

An aspect of the invention relates to a circuit breaker device for interrupting a current flow in an electrical circuit, wherein the current flow may be reversibly interrupted by means of the inventive circuit breaker device. The inventive circuit breaker device may be utilized for interrupting a flow of alternating current (AC) and/or a flow of direct current (DC).

According to an embodiment of the invention, the circuit breaker device comprises a first switch arrangement comprising a first silicon-based semiconductor switch and a second silicon-based semiconductor switch, which first silicon-based semiconductor switch and second silicon-based semiconductor switch are antisymmetrically interconnected with each other. The circuit breaker device further comprises a second switch arrangement comprising a first wide bandgap (WBG) semiconductor switch and a second wide bandgap semiconductor switch, which first wide bandgap semiconductor switch and second wide bandgap semiconductor switch are connected in series in a back-to-back arrangement. Therein, the first switch arrangement is arranged in parallel to the second switch arrangement.

Here and in the following the terms "first silicon-based semiconductor switch", "first semiconductor switch" and "first silicon switch", as well as the terms "second silicon-based semiconductor switch", "second semiconductor switch" and "second silicon switch" may be synonymously utilized. Further, the terms "first wide bandgap semiconductor switch" and "first wide bandgap switch", as well as the terms "second wide bandgap semiconductor switch" and "second wide bandgap switch" may be synonymously utilized.

The term "antisymmetric interconnection" of the first and second semiconductor switches may refer to an antiparallel arrangement and/or interconnection of the first and second semiconductor switches, and/or the term may refer to a series connection of the first and second semiconductor switches in a back-to-back arrangement.

Moreover, the term series connection in a back-to-back arrangement may refer to the respective switches being connected in series back-to-back. Therein, "back-to-back" may mean that a terminal of one type of a first switch is interconnected with a terminal of the same type of a second switch. For example, a source terminal of a first switch is connected to a source terminal of a second switch, or a drain terminal of a first switch is connected to a drain terminal of the second switch, or an emitter terminal of a first switch is connected to an emitter terminal of a second switch, or a collector terminal of a first switch is connected to a collector terminal of a second switch. Also a cathode terminals or anode terminals of two switches may be interconnected, for instance in case of thyristors. The respective terminals of the first and second switch may either be directly connected, i.e. they may be in direct contact, or they may be connected via some electrically conductive connection element.

Further, the term "wide bandgap" may refer to a semiconductor material, in which the bandgap, i.e. the respective energy difference between valence and conduction band, may be larger than 3 eV.

As already mentioned, a hybrid combination, and/or hybrid arrangement, and/or hybrid device of a silicon-based semiconductor switch and a WBG switch in parallel may generally be listed in terms of overall performance and cost compared to a full WBG device, i.e. a device employing solely WBG switches, and/or compared to a full silicon device, i.e. a device employing solely silicon-based semiconductor switches. By way of example, a hybrid combination of a silicon-based semiconductor switch, such as e.g. an insulated gate bipolar transistor (IGBT) and/or a reverse conducting IGBT, with a WBG switch, such as e.g. a voltage controlled unipolar switch, may provide an optimum thermal and conduction performance, e.g. due to low conduction losses. Also a switching performance and a fault conditions performance may be improved, e.g. due to low switching losses, switching softness, surge current capability, and/or short-circuit capability. An advantageous feature of such hybrid combination may be to reduce cost by using a minimum number of WBG devices, while maintaining the performance advantages provided by these WBG devices.

Concerning the inventive circuit breaker device, switching losses may be regarded a minor issue since switching events for interrupting the current flow in the circuit may usually be single events. Accordingly, a reduction of switching losses by using a hybrid combination or a hybrid device may only bring considerably minor benefits.

However, the inventive circuit breaker device employing a hybrid combination of Si-based semiconductor switches and WBG switches may advantageously provide low conduction losses under a full current range, for which the circuit breaker device may be utilized. This may allow the inventive circuit breaker device to compete with mechanical solutions for circuit breaker devices. Moreover, the inventive circuit breaker device may provide high breaking current turn-off capability for the switching events, i.e. the events in which the current flow in the circuit may be interrupted by means of the circuit breaker device. Although silicon-based bipolar semiconductor devices may provide comparable performance, they may not provide low conduction losses at low current due to the inherent built-in voltage of Silicon of around 0.7 V for forward biasing a p-n junction of the silicon-based switch. While unipolar switches, such as Metal-Oxide-Semiconductor Field-Effect Transistors (MOSFETs), may not suffer such constraints, these switches may require rather large area consumption to achieve the required low losses at high currents. With WBG switches, such as e.g. a Silicon-Carbide (SiC) MOSFET, these aspects may be improved, particularly for higher voltage switches, but at a rather large cost premium. Further, it is to be noted that such unipolar WBG switches may always have the drawback of lacking surge current capability when compared to bipolar silicon-based switches.

The inventive circuit breaker device may be regarded as a cross switch hybrid arrangement of silicon-based semiconductor switches and WBG switches connected in parallel. As may be desired for circuit breaker applications, the inventive circuit breaker device may advantageously provide bidirectional functionality with low (conduction) losses over the full current range, in which such circuit breaker devices may usually be applicable, combined with high turn-off current capabilities, while additionally providing surge current capabilities.

A further aspect of the invention relates to a method for interrupting a current flow in an electrical circuit with a circuit breaker device

It has to be understood that features of the method as described in the above and in the following may be features of the circuit breaker device as described in the above and in the following. Vice versa, features of the circuit breaker device may be features of the method.

If technically possible but not explicitly mentioned, also combinations of embodiments of the invention described in the above and in the following may be embodiments of the method and/or the circuit breaker device.

According to an embodiment of the invention, the first switch arrangement provides full bidirectionality and/or the first switch arrangement is a fully bidirectional switch arrangement. Further, the second switch arrangement provides full bidirectionality and/or the second switch arrangement is a fully bidirectional arrangement. Therein, full bidirectionality may comprise bidirectional conduction capability, bidirectional blocking capability and/or bidirectional control capability of the first and/or second switch arrangement.

The first switch arrangement may comprise a conducting state, in which a current through the first switch arrangement may be conductable in two directions and/or may be bidirectionally conductable, and a blocking state, in which the current through the first switch arrangement may be blockable in two directions and/or may be bidirectionally blockable.

Similarly, the second switch arrangement may comprise an on-state, in which a current through the second switch arrangement may be conductable in two directions and/or may be bidirectionally conductable, and an off-state, in which the current through the second switch arrangement may be blockable in two directions and/or may be bidirectionally blockable.

According to an embodiment of the invention, the first switch arrangement comprises at least one of an insulated gate bipolar transistor (IGBT), a diode, a reverse conducting insulated gate bipolar transistor (RC-IGBT), an integrated gate-commutated thyristor (IGCT), a reverse blocking integrated gate-commutated thyristor (RB-IGCT), a bi-mode insulated gate transistor (BIGT), a bidirectional thyristor, and a bidirectional turn-off thyristor. The bidirectional turn-off thyristor may refer to a bipolar gate turn-off thyristor. Either of these semiconductor switches may comprise at least one internal diode, which internal diode may be reverse conducting or reverse blocking.

By way of example and not restricting the scope of the invention, the first and second semiconductor switches may both be IGBTs, optionally comprising an internal or external diode, which diode may be a reverse conducting diode; the first and second semiconductor switches may both be RC-IGBTs; the first and second semiconductor switches may both be RB-IGCTs; the first and second semiconductor switches may both be bidirectional thyristors and/or bidirectional turn-off thyristors.

According to an embodiment of the invention, the first semiconductor switch and the second semiconductor switch of the first switch arrangement are reverse blocking switches, wherein the first semiconductor switch and the second semiconductor switch of the first switch arrangement are arranged antiparallel with respect to each other. The first and/or the second semiconductor switch may each comprise an internal and/or an external reverse blocking diode, wherein an internal diode may be integrated in the respective semiconductor switch.

Generally, in order to provide full bidirectionality, i.e. bidirectionality in terms of conduction capability, blocking capability, and/or control capability, two reverse blocking switches may be arranged antiparallel with respect to each other or two reverse conducting switches may be arranged and/or connected back-to-back in series.

Thus, in case both the first and the second semiconductor switches are reverse blocking switches, the antiparallel arrangement may provide full bidirectionality to the first switch arrangement, which in turn may be advantageous for circuit breaker applications, particularly for applications, in which an AC current in the electrical circuit is to be interrupted by means of the circuit breaker device. Further, in a back-to-back arrangement of series connected reverse conducting switches, such as e.g. IGBTs, MOSFETs and/or other planar termination based switches, conduction losses resulting from the series connection may be higher when compared to the antiparallel arrangement of two reverse blocking switches, since only one of the first and second semiconductor switches may be required per direction of current flow through the first switch arrangement. In other words, the antiparallel arrangement of the first and second reverse blocking semiconductor switches may reduce conduction losses and thus may improve an energy efficiency of the entire circuit breaker device.

According to an embodiment of the invention, the first semiconductor switch is an RB-IGCT and the second semiconductor switch is an RB-IGCT arranged antiparallel to the first semiconductor switch. However, the first and/or second semiconductor switch may alternatively be bidirectional thyristors and/or bidirectional turn-off thyristors. RB-IGCTs may comprise a bipolar termination, e.g. with double sided bevels, and may advantageously improve the energy efficiency of the circuit breaker device by reducing conduction losses.

According to an embodiment of the invention, the first semiconductor switch and the second semiconductor switch of the first switch arrangement are reverse conducting switches, wherein the first semiconductor switch and the second semiconductor switch are series connected in a back-to-back arrangement. For instance an emitter terminal of the first semiconductor switch may be interconnected with an emitter terminal of the second semiconductor switch, either directly or indirectly by means of an electrically conductive element. As mentioned above, the back-to-back arrangement of series connected reverse conducting switches may advantageously provide full bidirectionality to the first switch arrangement. Reverse conducting capability may be provided to each of the first and second semiconductor switches by means of an internal or an external diode. By way of example and not restricting the scope of the invention, both the first and the second semiconductor switches may be IGBTs, each connected to an external reverse conducting diode to provide reverse conduction capability. Moreover, both the first and second semiconductor switches may be RC-IGBTs, or the first semiconductor switch may be an IGBT with external reverse conducting diode and the second semiconductor switch may be an RC-IGBT.

According to an embodiment of the invention, the first semiconductor switch and/or the second semiconductor switch of the first switch arrangement comprises an internal reverse conducting diode. This may render an external reverse conducting diode superfluous and may thus allow a compact design of the circuit breaker device.

According to an embodiment of the invention, the first wide bandgap switch and the second wide bandgap switch of the second switch arrangement each have no built-in voltage and/or each have a built-in voltage of zero Volts. The first and second wide bandgap switches may lack a built-in voltage due to an absence of a pn junction and/or any other barrier type. In other words, the first and second wide bandgap switches may be e.g. unipolar semiconductor switches. This may further improve the energy efficiency of the circuit breaker device as low conduction losses may be achieved even at considerably low currents below e.g. 10 A.

According to an embodiment of the invention, the first wide bandgap switch and the second wide bandgap switch of the second switch arrangement are voltage-controlled switches. The term "voltage controlled switch" may relate to a switch and/or semiconductor device, whose output characteristics are determined and/or controlled by an electrical field depending on the voltage applied to the gate terminal of the respective switch. For example, a MOSFET, a junction-gate field-effect transistor (JFET), and/or a high electron mobility transistor (HEMT) may be utilized as wide band-gap switch. Further, the first and the second WBG switches may be voltage-controlled unipolar switches.

According to an embodiment of the invention, the first wide band-gap switch and/or the second wide band-gap switch is a MOSFET.

According to an embodiment of the invention, the first wide band-gap switch and the second wide band-gap switch of the second switch arrangement are based on silicon carbide (SiC) and/or on gallium nitride (GaN). For example, a SiC MOSFET and/or a GaN HEMT may be utilized as first and/or second wide bandgap switch. Such switches may particularly provide low losses at low currents.

According to an embodiment of the invention, the current in the circuit is interruptable by switching the second switch arrangement to an off-state, in which at least one of the first and second wide bandgap switches is turned off, and by switching the first switch arrangement to a blocking state, in which at least one of the first semiconductor switch and the second semiconductor switch is blocking a current flow through the first switch arrangement. The second switch arrangement may be switched to the off-state by applying an appropriate gate signal to a gate terminal of at least one of the WBG switches, wherein the gate signal may be a positive/negative gate current signal or a positive/negative gate voltage signal, depending on the characteristic of the first and second WBG switches. Similarly, the first switch arrangement may be switched to the blocking state by applying an appropriate gate signal to a gate terminal of at least one of the first and second semiconductor switches, wherein the gate signal may be a positive/negative gate current signal or a positive/negative gate voltage signal, depending on the characteristic of the first and second semiconductor switches.

According to an embodiment of the invention, the second switch arrangement is switched to the off-state by applying a negative gate signal to a gate terminal of the first wide bandgap switch and/or to a gate terminal of the second wide bandgap switch. For instance, in case the first and/or second WBG switch is a voltage controlled SiC MOSFET, the gate signal may be a negative gate voltage signal applied to the SiC MOSFET's gate terminal in order to turn the switch off.

A further aspect of the invention relates to a use of a first switch arrangement arranged parallel to a second switch arrangement in a circuit breaker device for interrupting a current flow in an electrical circuit. The first switch arrangement is a bidirectional switch arrangement comprising two silicon-based semiconductor switches, and the second switch arrangement is a back-to-back arrangement of at least two wide bandgap semiconductor switches connected in series. The two silicon-based semiconductor switches of the first switch arrangement may be connected antiparallel or they may be series connected back-to-back, as described in the above and in the following.

Yet a further aspect of the invention relates to a method for interrupting a current flow in an electrical circuit with a circuit breaker device as described in the above and in the following. The method comprises the steps of switching the second switch arrangement to an off-state by applying a negative gate signal to a gate terminal of at least one of the first and second wide bandgap switch of the second switch arrangement, and switching the first switch arrangement to a blocking state by applying a turn-off gate signal to a gate terminal of at least one of the first and second semiconductor switches of the first switch arrangement. Therein, the second switch arrangement is switched to the off-state prior to switching the first switch arrangement to the blocking state by a predefined delay time. Switching the second switch arrangement to the off-state prior to switching the first switch arrangement to the blocking state may avoid damages to the second switch arrangement, as the first and second WBG switches may not be capable to carry excessive amounts of current.

According to an embodiment of the invention, the delay time is in the range of 5 µs to 500 µs. The delay time may for example range from 10 µs to 100 µs, and preferably from 10 µs to 50 µs.

These and other aspects of the invention will be apparent from and elucidated with reference to the embodiments described hereinafter.

### BRIEF DESCRIPTION OF THE DRAWINGS

The subject matter of the invention will be explained in more detail in the following text with reference to exemplary embodiments which are illustrated in the attached drawings.
Fig. 1 schematically shows a circuit breaker device according to an embodiment of the invention.
Fig. 2A schematically shows a circuit breaker device according to an embodiment of the invention.
Fig. 2B schematically shows forward characteristics of components of the circuit breaker device of Fig. 2A.
Fig. 3 shows a flow chart illustrating steps of a method for interrupting current flow according to an embodiment of the invention.

The reference symbols used in the drawings, and their meanings, are listed in summary form in the list of reference symbols. In principle, identical parts are provided with the same reference symbols in the figures.

### DETAILED DESCRIPTION OF EXEMPLARY EMBODIMENTS

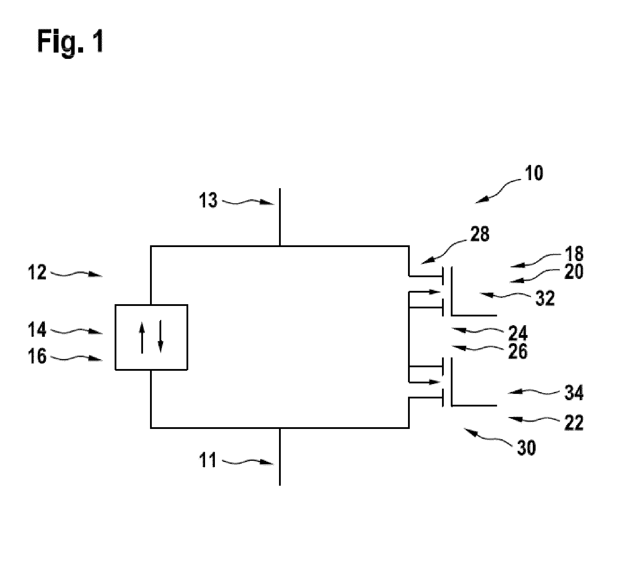

Fig. 1 schematically shows a circuit breaker device 10 for interrupting a current flow in an electrical circuit according to an embodiment of the invention.

The circuit breaker device 10 comprises an input 11 and an output 13 for connecting and/or integrating the circuit breaker device 10 in the electrical circuit, in which the current flow may be interrupted by means of the circuit breaker device 10.

The circuit breaker device 10 comprises a first switch arrangement 12 arranged and/or connected in parallel to a second switch arrangement 18.

The first switch arrangement 12 comprises a first silicon-based semiconductor switch 14 and a second silicon-based semiconductor switch 16. The first and the second silicon switches 14, 16 are antisymmetrically interconnected with each other and/or antisymmetrically arranged with respect to each other. This means the first and the second silicon switches 14, 16 may either be arranged and/or interconnected antiparallel or the first and second silicon switches 14, 16 may be series connected back-to-back. The first switch arrangement 12 is adapted for providing full bidirectionality in terms of conduction capability, blocking capability, and /or control capability. Accordingly, the first switch arrangement 12 comprises a conducting state, in which current may flow through the first switch arrangement 12 in both directions, i.e. from input 11 to output 13 or from output 13 to input 11. Further, the first switch arrangement 12 comprises a blocking state, in which the current flow through the first switch arrangement 12 may be blocked in both directions, i.e. from input 11 to output 13 and from output 13 to input 11.

To achieve the bidirectionality, the actual arrangement of the first and second silicon switches 14, 16 may depend on their characteristics and/or specifications, as outlined above. In case both the first and the second silicon switches 14, 16 are reverse conducting switches, the first and second silicon switches 14, 16 may be series connected back-to-back in order to provide full bidirectionality to the first switch arrangement 12. Therein, a reverse conducting capability may be provided to the first and/or second silicon switch 14, 16 e.g. by an internal diode integrated in the first and/or second silicon switch 14, 16 or by an external diode, which may be connected to the first and/or second silicon switch 14, 16, for instance by means of a conduction element. In case both the first and the second silicon switches 14, 16 are reverse blocking switches, bidirectionality may be provided by arranging and/or interconnecting the first and the second silicon switches 14, 16 antiparallel with respect to each other.

By way of example and not restricting the scope of the invention, the following combinations of the first and the second silicon switches 14, 16 may be conceivable.

The first silicon switch 14 may be an IGBT with internal or external reverse conducting diode, and the second silicon switch 16 may be an IGBT with internal or external reverse conducting diode, wherein the first and second silicon switches 14, 16 are series connected back-to-back, i.e. a collector terminal of the first silicon switch 14 may be interconnected with a collector terminal of the second silicon switch 16. The respective collector terminals may be in direct contact or interconnected by means of a conduction element.

Further, both the first and the second silicon switches 14, 16 may be RC-IGBTs series connected back-to-back, with the respective collector terminals of the first and second silicon switches 14, 16 being interconnected.

The first silicon switch 14 may be an IGBT with internal or external reverse conducting diode, and the second silicon switch 16 may be an RC-IGBT series connected back-to-back with the first silicon switch 14, the respective collector terminals of the first and second silicon switches 14, 16 being interconnected.

Further, both the first and the second silicon switch es14, 16 may be RB-IGCTs connected and/or arranged antiparallel with respect to each other, wherein a collector terminal of one of the first and the second silicon switches 14, 16 may be directly connected to and/or may be directed towards the input 11, whereas the collector terminal of the other one of the first and second silicon switches 14, 16 may be directly connected and/or may be directed towards the output 13.

Both the first and the second silicon switches 14, 16 may be bidirectional (gate) turn-off thyristors connected and/or arranged antiparallel, wherein respective anodes of the first and the second silicon switches 14, 16 may be directed in opposite directions with respect to each other.

Both the first and the second silicon switches 14, 16 may be bidirectional thyristors connected and/or arranged antiparallel, wherein respective anodes of the first and the second silicon switches 14, 16 may be directed in opposite directions with respect to each other.

Further the first silicon switch 14 may be a bidirectional thyristor and the second silicon switch 16 may be a bidirectional (gate) turn-off thyristor arranged antiparallel to the first silicon switch 14.

Further, the first silicon switch 14 may be an RB-IGCT arranged antiparallel to the second silicon switch 16, which may be a bidirectional thyristor or a bidirectional (gate) turn-off thyristor.

The second switch arrangement 18 of the circuit breaker device 10, which second switch arrangement 18 is parallel connected to the first switch arrangement 12, comprises a first wide bandgap (WBG) switch 20 and a second wide bandgap switch 22. The first and the second WBG switches 20, 22 are series connected back-to-back, wherein a source terminal 24 of the first WBG switch 20 is connected to a source terminal 26 of the second WBG switch 22. The source terminals 24, 26 may be directly connected, e.g. by direct contact of both source terminals 24, 26, or they may be connected via a conduction element. Further, a drain terminal 28 of the first WBG switch 20 is connected to the output 13 and a drain terminal 30 of the second WBG switch is connected to the input 11.

The first WBG switch 20 comprises a gate terminal 32 and the second WBG switch 22 comprises a gate terminal 34, allowing control of the corresponding first or second WBG switch 20, 22. Both gate terminals 32, 34 may be interconnected by means of a common gate unit of the second switch arrangement 18, thereby simplifying control of the second switch arrangement 18.

The first and the second WBG switches 20, 22 may be voltage-controlled, and they may basically be unipolar or bipolar semiconductor switches, respectively. However, in order to achieve low conduction losses at low currents flowing through the second switch arrangement 18, e.g. currents below 10 A, it might be advantageous to design the first and the second WBG switches 20, 22 as unipolar voltage-controlled switches.

The first and the second WBG switches 20, 22 may for instance be MOSFETs and/or HEMTs. The first and/or the second WBG switches 20, 22 may for instance be based on SiC and/or on GaN. Preferably, both the first and the second WBG switches 20, 22 are SiC MOSFETs having no built-in voltage, thereby reducing conduction losses at low currents. However, it might be conceivable to design one of or both of the first and second WBG switches 20, 22 as GaN HEMT.

In order to interrupt the flow of current in the circuit, which may be an AC current or a DC current, by means of the circuit breaker device 10, the second switch arrangement 20 may be switched from an on-state, in which current may flow through the second switch arrangement 18 at least in one direction, to an off-state, in which a current flow through the second switch arrangement 18 may be blocked in at least one direction. The second switch arrangement 18 may be switched to the off-state by supplying a gate signal to at least one of the gate terminals 32, 34 of the first and/or second WBG switch 20, 22, which gate signal may be adapted for turning-off the corresponding first and/or second WBG switch 20, 22. Characteristics of the applied gate signal, such as e.g. a signal strength, a signal voltage, a signal current and/or a signal sign, may depend on the characteristics and specifications of the respective first and/or second WBG switch 20, 22. For example, in case both the first and the second WBG switches 20, 22 are SiC MOSFETs they may be conducting and/or they may be turned-on if a positive gate voltage is applied to the respective gate terminal 32, 34 of the first and/or second WBG switch 20, 22. The first and/or second WBG switch 20, 22 may be turned-off by applying a negative voltage to the respective gate terminal 32, 34. Accordingly, for switching the second switch arrangement 18 to the off-state, a negative gate voltage signal may be applied to at least one of the first and the second WBG switch 20, 22, in order to interrupt current flowing through the second switch arrangement 18.

To further interrupt a current flowing through the first switch arrangement 12, and thus to interrupt the current flowing between input 11 and output 13, the first switch arrangement 12 is switched to the blocking state, by applying at least one appropriate gate signal to a gate terminal of at least one of the first and the second silicon switches 14, 16 in order to turn-off the respective at least one of the first and the second silicon switch 14, 16. Also characteristics of this at least one gate signal may depend on the characteristics and specifications of the corresponding first and/or second silicon switch 14, 16.

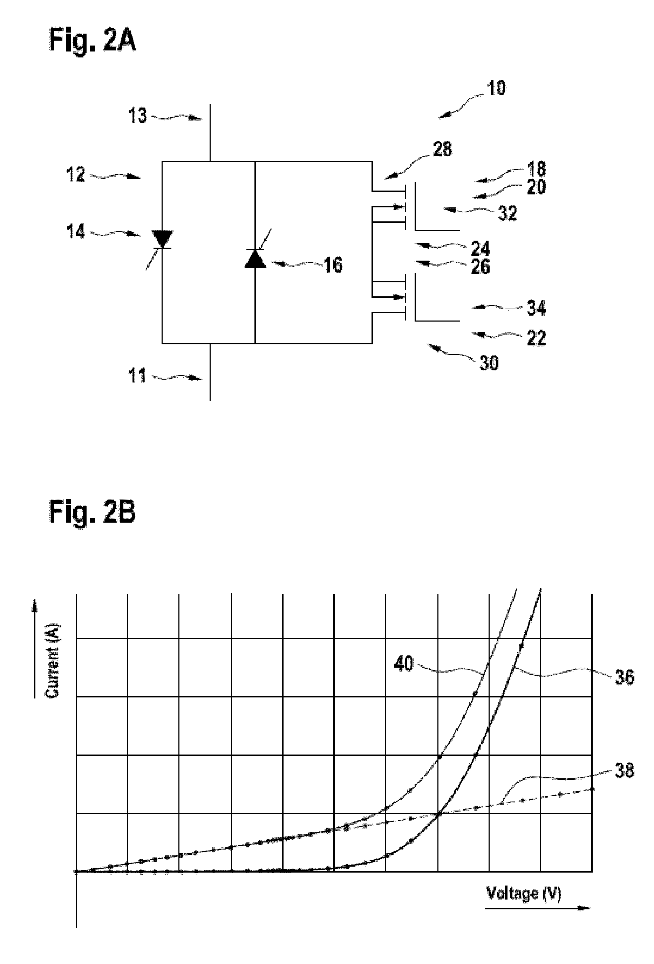

Fig. 2A schematically shows a circuit breaker device 10 according to an embodiment of the invention. Fig. 2B schematically shows forward characteristics of components of the circuit breaker device 10 of Fig. 2A. If not stated otherwise, the circuit breaker device 10 of Fig. 2A may comprise the same elements, features and/or functions as the circuit breaker device of Fig. 1.

Referring to Fig. 2A, the circuit breaker device 10 comprises a first switch arrangement 12 with a first RB-IGCT 14 employed as first semiconductor switch connected and/or arranged antiparallel to a second RB-IGCT 16 employed as second semiconductor switch, thereby providing full bidirectionality to the first switch arrangement 12.

The circuit breaker device 10 further comprises a second switch arrangement 18 connected in parallel to the first switch arrangement 12. The second switch arrangement 18 comprises a first SiC MOSFET 20 as first WBG switch and a second SiC MOSFET 22 as second WBG switch. The first and the second SiC MOSFETs 20, 22 are series connected back-to-back with their respective source terminals 24, 26 being interconnected.

An operational mode of the circuit breaker device 10 may involve at least two separate gate units for the first switch arrangement 12 and the second switch arrangement 18. Accordingly, a gate terminal of the first RB-IGCT 14 and a gate terminal of the second RB-IGCT 16 may be connected to a first common gate unit for controlling the first switch arrangement 12, i.e. for controlling both the first and the second RB-IGCTs 14, 16. However, the gate terminals of the first and second RB-IGCTs 14, 16 may also be independently controlled. Further, the gate terminals 32, 34 of the first and second SiC MOSFETs 20, 22 may be connected to a second common gate unit for controlling the second switch arrangement 18, i.e. for controlling both the first and the second SiC MOSFETs 20, 22. However, the gate terminals 32, 34 may also be independently controlled.

During conduction in at least one direction, at least one of the first and second RB-IGCT 14, 16 may be forward biased and/or fired and/or switched into the conducting state while a positive gate voltage is applied on both gate terminals 32, 34 of the first and second SiC MOSFETs 20, 22, thereby switching the second switch arrangement 18 to the on-state. In the on-state of the second switch arrangement 18 it may be benefitted from the bidirectional current capability of the MOSFET structure of each of the first and second SiC MOSFETs 20, 22, wherein it may not be required to use and/or switch at least one of an internal MOSFET Positive-Intrinsic-Negative (PIN) diode to be conducting. This may be possible due to the comparably high-built in voltage of the SiC PIN diode of approximately above 2.5 V and the very low conduction losses of the RB-IGCTs 14, 16 and the MOSFET of the first and second SiC MOSFETs 20, 22.

For a turn-off event, in which the current in the electrical circuit may be interrupted by interrupting the current flow through the circuit breaker device 10 between input 11 and output, a negative gate voltage signal is applied to at least one of the gate terminals 32, 34 of the first and second SiC MOSFET 20, 22, and/or a negative voltage signal is applied to the second common gate unit of the second switch arrangement 14. By means of the negative voltage signal applied, at least one of the first and the second SiC MOSFET 20, 22 is turned-off, the second switch arrangement 14 is switched to the off-state and any current may solely flow through the first switch arrangement 12. Following the negative gate voltage signal applied to the second switch arrangement 18, a turn-off gate signal is applied to at least one of the gate terminals of the first and second RB-IGCTs 14, 16 and/or to the first common gate unit of the first switch arrangement 12. By means of the turn-off gate signal the first switch arrangement 12 is switched to the blocking state, thereby blocking current flow through the first switch arrangement 12, and thereby blocking current flow between input 11 and output 13 and blocking current flow in the electrical circuit connected to input 11 and/or output 13. The turn-off gate signal applied to the first switch arrangement 12 may for instance be a negative gate voltage signal. The second switch arrangement 18 is switched to the off-state prior to switching the first switch arrangement 12 to the blocking state in order to avoid potential damage to the second switch arrangement 18 if all current would be channelled through the second switch arrangement 18. The first switch arrangement 12 may be switched to the blocking state after a predefined and/or defineable delay time after switching the second switch arrangement 18 to the off-state. The delay time may be in the range of 5 µs to 500 µs, preferably in the range of 10 µs to 50 µs.

Referring to Fig. 2B the advantages of the inventive circuit breaker device 10 are clearly visible. In Fig. 2B voltage drops of the first switch arrangement 12, of the second switch arrangement 18, and of the parallel connected first and second switch arrangements 12, 18, i.e. of the circuit breaker device 10, are shown as a function of the current applied, i.e. on-state curves 36, 38, 40 of the respective devices are shown. The x-axis refers to the voltage drop in Volts and the y-axis refers to the applied current in Ampere, wherein both the x-axis and the y-axis are shown in log-scale. Curve 36 corresponds to the forward characteristics of the first switch arrangement 12 with two antiparallel RB-IGCTs 14, 16, curve 38 corresponds to the forward characteristics of the second switch arrangement 18 with two series back-to-back connected SiC MOSFETs 20, 22, and curve 40 corresponds to the parallel arrangement of the first and second switch arrangements 12, 18, which may be regarded as full cross hybrid switch.

As multiplication of a voltage value with a corresponding current value refers to a power loss of the respective device, the advantageous of the inventive circuit breaker device 10 are clearly visible. As can be seen, low conduction losses are achieved by the inventive circuit breaker device 10 over the full range of current. Low conduction losses are particularly obtained at partial load conditions, e.g. around 100 A, where curves 38 and 40 indicate a voltage drop of around 0.38 V, whereas the voltage drop of the two RB-IGCTS 14, 16 illustrated by curve 36 is around 0.65 V.

It is worthwhile noting that for very low voltage ratings below approximately 800 V and currents below approximately 50 A, it may be possible to employ Silicon MOSFETs, such as e.g. a CoolMOS, instead of the WBG switches 20, 22 in parallel to the first switch arrangement 12 employing e.g. silicon bipolar devices, such as IGBTs and/or IGCTs as first and second silicon switches 14, 16 in order to achieve similar advantage in terms of low conduction losses at low currents. However, higher currents and/or higher voltage ratings may not be processed by such circuit breaker device.

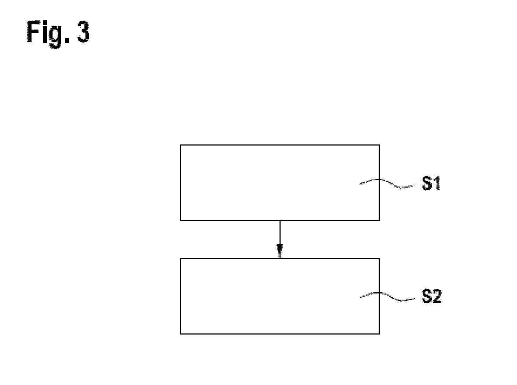

Fig. 3 shows a flow chart illustrating steps of a method for interrupting current flow in an electrical circuit with a circuit breaker device 10 according to an embodiment of the invention.

In a first step S1 the second switch arrangement 18 is switched to an off-state by applying a negative gate voltage signal to a gate terminal 32, 34 of at least one of the first and second wide bandgap switch 20, 22 of the second switch arrangement 18.

In a second step S2 the first switch arrangement 12 is switched to a blocking state by applying a turn-off gate signal to a gate terminal of at least one of the first and second semiconductor switches 14, 16 of the first switch arrangement 18.

Step S2 is carried out after step S1 after a predefined delay time ranging approximately from 5 µs to 500 µs, and preferably from about 10 µs to 50 µs.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art and practising the claimed invention, from a study of the drawings, the disclosure, and the appended claims. In the claims, the word "comprising" does not exclude other elements or steps, and the indefinite article "a" or "an" does not exclude a plurality. A single processor or controller or other unit may fulfil the functions of several items recited in the claims. The mere fact that certain measures are recited in mutually different dependent claims does not indicate that a combination of these measures cannot be used to advantage. Any reference signs in the claims should not be construed as limiting the scope.

### LIST OF REFERENCE SYMBOLS

- 10: circuit breaker device
- 11: input
- 12: first switch arrangement
- 13: output
- 14: first silicon-based semiconductor switch
- 16: second silicon-based semiconductor switch
- 18: second switch arrangement
- 20: first wide bandgap switch
- 22: second wide bandgap switch
- 24: source terminal of first WBG switch
- 26: source terminal of second WBG switch
- 28: drain terminal of first WBG switch
- 30: drain terminal of second WBG switch
- 32: gate terminal of first WBG switch
- 34: gate terminal of second WBG switch
- 36: forward characteristics of first switch arrangement
- 38: forward characteristics of second switch arrangement
- 40: forward characteristics of circuit breaker device

## Claims

1. A circuit breaker device (10) for interrupting a current flow in an electrical circuit, the circuit breaker device (10) comprising:
a first switch arrangement (12) comprising a first silicon-based semiconductor switch (14) and a second silicon-based semiconductor switch (16), which are antisymmetrically interconnected with each other; and
a second switch arrangement (18) comprising a first wide bandgap semiconductor switch (20) and a second wide bandgap semiconductor switch (22), which are series connected in a back-to-back arrangement,
wherein the first switch arrangement (12) is arranged in parallel to the second switch arrangement (18).

2. The circuit breaker device (10) according to claim 1,
wherein the first switch arrangement (12) comprises at least one of an IGBT, a diode, an RC-IGBT, an RB-IGCT, a BIGT, a bidirectional thyristor, and a bidirectional turn-off thyristor.

3. The circuit breaker device (10) according to one of the preceding claims,
wherein the first semiconductor switch (14) and the second semiconductor switch (16) of the first switch arrangement (12) are reverse blocking switches; and wherein the first semiconductor switch (14) and the second semiconductor switch (16) of the first switch arrangement (12) are arranged antiparallel with respect to each other.

4. The circuit breaker device (10) according to one of the preceding claims,
wherein the first semiconductor switch (14) is an RB-IGCT and the second semiconductor switch (16) is an RB-IGCT arranged antiparallel to the first semiconductor switch (14).

5. The circuit breaker device (10) according to one of claims 1 or 2,
wherein the first semiconductor switch (14) and the second semiconductor switch (16) of the first switch arrangement (12) are reverse conducting switches; and wherein the first semiconductor switch (14) and the second semiconductor switch (16) are series connected in a back-to-back arrangement.

6. The circuit breaker device (10) according to claim 5,
wherein the first semiconductor switch (14) and/or the second semiconductor switch (16) of the first switch arrangement (12) comprises an internal reverse conducting diode.

7. The circuit breaker device (10) according to one of the preceding claims,
wherein the first wide bandgap switch (20) and the second wide bandgap switch (22) of the second switch arrangement (18) each having no built-in voltage.

8. The circuit breaker device (10) according to one of the preceding claims,
wherein the first wide bandgap switch (20) and the second wide bandgap switch (22) of the second switch arrangement (18) are voltage-controlled switches.

9. The circuit breaker device (10) according to one of the preceding claims,
wherein the first wide bandgap switch (20) and/or the second wide bandgap switch (22) is a MOSFET.

10. The circuit breaker device (10) according to one of the preceding claims,
wherein the first wide bandgap switch (20) and the second wide bandgap switch (22) of the second switch arrangement (18) are based on silicon carbide and/or on gallium nitride.

11. The circuit breaker device (10) of one of the preceding claims,
wherein the current in the circuit is interruptable by switching the second switch arrangement (18) to an off-state, in which at least one of the first wide bandgap switch (22) and second wide bandgap switch (22) is turned off, and by switching the first switch arrangement (12) to a blocking state, in which at least one of the first semiconductor switch (14) and the second semiconductor switch (16) is blocking a current flow through the first switch arrangement (12).

12. The circuit breaker device (10) according to claim 11,
wherein the second switch arrangement (18) is switched to the off-state by applying a negative gate signal to a gate terminal (32) of the first wide bandgap switch (20) and/or to a gate terminal (34) of the second wide bandgap switch (22).

13. Use of a first switch arrangement (12) arranged parallel to a second switch arrangement (18) in a circuit breaker device (10) for interrupting a current flow in an electrical circuit,
wherein the first switch arrangement (12) is a bidirectional switch arrangement comprising two silicon-based semiconductor switches (14, 16), and
wherein the second switch arrangement (18) is a back-to-back arrangement of at least two wide bandgap semiconductor switches (20, 22) connected in series.

14. A method for interrupting a current flow in an electrical circuit with a circuit breaker device (10) according to one of claims 1 to 12, the method comprising the steps of:
switching the second switch arrangement (18) to an off-state by applying a negative gate signal to a gate terminal of at least one of the first wide bandgap switch (20) and the second wide bandgap switch (22) of the second switch arrangement (18); and
switching the first switch arrangement (12) to a blocking state by applying a turn-off gate signal to a gate terminal of at least one of the first silicon-based semiconductor switch (14) and the second silicon-based semiconductor switch (16) of the first switch arrangement (12),
wherein the second switch arrangement (18) is switched to the off-state prior to switching the first switch arrangement (12) to the blocking state by a predefined delay time.

15. The method according to claim 14,
wherein the delay time is in the range of 5 to 500 µs.
